# EUROPEAN PATENT APPLICATION

(11) **EP 4 712 500 A1**
(43) Date of publication of application: **18.03.2026**
(21) Application number: 24803278.1
(22) Date of filing: 15.03.2024
(51) Int. Cl.: H04N 25/78, H03M 1/38, H03M 1/46

(54) **AD (ANALOG TO DIGITAL) CONVERTER, IMAGING DEVICE, AND METHOD FOR CONTROLLING AD CONVERTER**

(30) Priority: 10.05.2023 JP 2023077586
(71) Applicant: Sony Semiconductor Solutions Corporation, Atsugi-shi, Kanagawa 243-0014 (JP)
(72) Inventor: HINO, Yasufumi, Atsugi-shi, Kanagawa 243-0014 (JP); ETOU, Shinichirou, Atsugi-shi, Kanagawa 243-0014 (JP)
(74) Representative: Müller Hoffmann & Partner
(86) International application number: PCT/JP2024/010226
(87) International publication number: WO 2024/232163

(57) **Abstract**

The present technology is intended to enhance the speed of a successive approximation AD converter while suppressing an increase in circuit size.

An analog to digital (AD) converter includes a first digital-to-analog converter (DAC), a second DAC, and a comparison unit. Furthermore, the first DAC has a capacitor that holds a first input signal during a first sampling period. Furthermore, the second DAC has a capacitor that holds a second input signal during a second sampling period. Furthermore, the comparison unit is connected to the first and second DACs.

## Description

### TECHNICAL FIELD

The present technology relates to an AD converter. More specifically, the present technology relates to a successive approximation AD converter, an imaging device, and a method for controlling the AD converter.

### BACKGROUND ART

A successive approximation register analog to digital converter (SARADC) has been widely used in various electronic devices because of its high resolution and low power consumption. For example, a time-interleaved AD converter equipped with a plurality of SARADCs that performs sampling at different time instants has been proposed (see, for example, Non-Patent Document 1).

### CITATION LIST

### NON-PATENT DOCUMENT

Non-Patent Document 1: Yuan Zhou, et al., A 12-b 1-GS/s 31.5-mW Time-Interleaved SAR ADC With Analog HPF-Assisted Skew Calibration and Randomly Sampling Reference ADC, IEEE JOURNAL OF SOLID-STATE CIRCUITS, VOL. 54, NO. 8, AUGUST 2019.

### SUMMARY OF THE INVENTION

### PROBLEMS TO BE SOLVED BY THE INVENTION

The related technology described above employs the time-interleaved method to enhance the speed of AD conversion. However, the related technology described above requires a plurality of SARADCs, leading to an increase in circuit size compared to a case where the time-interleaved method is not employed. When only one SARADC is provided, the circuit size can be reduced, but it becomes impossible to achieve speed enhancement using the time-interleaved method. As described above, it is difficult for the related technology described above to achieve speed enhancement while suppressing an increase in circuit size.

The present technology has been made in view of such circumstances, and it is therefore an object of the present technology to enhance the speed of a successive approximation AD converter while suppressing an increase in circuit size.

### SOLUTIONS TO PROBLEMS

The present technology has been made to solve the above-described problems, and according to a first aspect of the present technology, there are provided an AD converter and a method for controlling the AD converter, the AD converter including: a first digital-to-analog converter (DAC) having a capacitor that holds a first input signal during a first sampling period; a second DAC connected in parallel with the first DAC and having a capacitor that holds a second input signal during a second sampling period; and a comparison unit connected to the first and second DACs. This brings about an effect of suppressing an increase in circuit size when achieving speed enhancement.

Furthermore, in the first aspect, a single-ended to differential conversion circuit that converts a first single-ended signal into a first differential signal and converts a second single-ended signal into a second differential signal, a first sample-and-hold switch that supplies the first differential signal to the first DAC as the first input signal during the first sampling period, and a second sample-and-hold switch that supplies the second differential signal to the second DAC as the second input signal during the second sampling period may be further included. This brings about an effect that the differential signal is AD-converted.

Furthermore, in the first aspect, a first sample-and-hold switch that supplies a first single-ended signal to the first DAC as the first input signal during the first sampling period, a second sample-and-hold switch that supplies a second single-ended signal to the second DAC as the second input signal during the second sampling period; a shared DAC, a first single-ended to differential conversion circuit that converts the first input signal into a differential signal and supplies the differential signal to the first DAC and the shared DAC in an interval between end of the first sampling period and start of the second sampling period, and a second single-ended to differential conversion circuit that converts the second input signal into a differential signal and supplies the differential signal to the second DAC and the shared DAC in an interval between end of the second sampling period and start of the first sampling period may be further included. This brings about an effect of reducing the number of DACs.

Furthermore, in the first aspect, a first sample-and-hold switch that supplies a first single-ended signal and a reference signal to the first DAC as the first input signal during the first sampling period, and a second sample-and-hold switch that supplies a second single-ended signal and the reference signal to the second DAC as the second input signal during the second sampling period may be further included.

Furthermore, in the first aspect, a logic circuit that generates a second control signal on the basis of a comparison result of the comparison unit during the first sampling period and generates a first control signal on the basis of a comparison result of the comparison unit during the second sampling period may be further included, in which the first DAC may generate a pair of first analog signals on the basis of the first control signal and the first input signal during the second sampling period, the second DAC may generate a pair of second analog signals on the basis of the second control signal and the second input signal during the first sampling period, and the comparison unit may sequentially compare the pair of first analog signals and the pair of second analog signals. This brings about an effect that sampling and AD conversion are performed in parallel.

Furthermore, in the first aspect, a first enable switch that supplies the pair of first analog signals to the comparison unit during the second sampling period, and a second enable switch that supplies the pair of second analog signals to the comparison unit during the first sampling period may be further included. This brings about an effect of enabling switching of the signal input to the comparison unit.

Furthermore, in the first aspect, the first DAC may supply the pair of first analog signals to the comparison unit, the second DAC may supply the pair of second analog signals to the comparison unit, and the comparison unit may select and compare the pair of second analog signals or the pair of first analog signals in accordance with a predetermined enable signal. This brings about an effect of removing the switches on the input side of the comparison unit.

Furthermore, in the first aspect, a third DAC connected in parallel with the first and second DACs and having a capacitor that holds a third input signal during a third sampling period may be further included.

Furthermore, according to a second aspect of the present technology, there is provided an imaging device including: a pixel array unit including a plurality of pixels, each outputting a pixel signal; and an AD converter to which the pixel signal is input from the pixel array unit, in which the AD converter includes: a first DAC having a capacitor that holds a first input signal during a first sampling period; a second DAC connected in parallel with the first DAC and having a capacitor that holds a second input signal during a second sampling period, and a comparison unit connected to the first and second DACs. This brings about an effect of suppressing an increase in circuit size when enhancing the speed of AD conversion in the imaging device.

### BRIEF DESCRIPTION OF DRAWINGS

Fig. 1 is a block diagram illustrating a configuration example of an imaging device according to a first embodiment of the present technology.
Fig. 2 is a block diagram illustrating a configuration example of a solid-state imaging element according to the first embodiment of the present technology.
Fig. 3 is a block diagram illustrating a configuration example of a pixel according to the first embodiment of the present technology.
Fig. 4 is a block diagram illustrating a configuration example of a column signal processing unit according to the first embodiment of the present technology.
Fig. 5 is a block diagram illustrating a configuration example of the column signal processing unit further including a sample-and-hold circuit and a column amplifier according to the first embodiment of the present technology.
Fig. 6 is a block diagram illustrating a configuration example of an SARADC according to the first embodiment of the present technology.
Fig. 7 is a block diagram illustrating a configuration example of a control unit according to the first embodiment of the present technology.
Fig. 8 is a circuit diagram illustrating a configuration example of a comparison unit according to the first embodiment of the present technology.
Fig. 9 is a timing chart illustrating an example of operation of the SARADC according to the first embodiment of the present technology.
Fig. 10 illustrates examples of a block diagram and timing chart of an SARADC according to a first comparative example.
Fig. 11 is a block diagram illustrating a configuration example of an AD converter according to a second comparative example.
Fig. 12 is a timing chart illustrating an example of operation of the AD converter according to the second comparative example.
Fig. 13 is a flowchart illustrating an example of operation of the solid-state imaging element according to the first embodiment of the present technology.
Fig. 14 is a block diagram illustrating a configuration example of an SARADC according to a second embodiment of the present technology.
Fig. 15 is a block diagram illustrating a configuration example of a control unit according to the second embodiment of the present technology.
Fig. 16 is a timing chart illustrating an example of operation of the SARADC according to the second embodiment of the present technology.
Fig. 17 is a block diagram illustrating a configuration example of an SARADC according to a third embodiment of the present technology.
Fig. 18 is a block diagram illustrating a configuration example of the SARADC with single-sided CDAC control according to the third embodiment of the present technology.
Fig. 19 is a block diagram illustrating a configuration example of an SARADC according to a fourth embodiment of the present technology.
Fig. 20 is a block diagram illustrating a configuration example of a control unit according to the fourth embodiment of the present technology.
Fig. 21 is a circuit diagram illustrating a configuration example of a comparison unit according to the fourth embodiment of the present technology.
Fig. 22 is a block diagram illustrating a configuration example of a column signal processing unit according to a fifth embodiment of the present technology.
Fig. 23 is a block diagram illustrating a configuration example of an SARADC according to the fifth embodiment of the present technology.
Fig. 24 is a timing chart illustrating an example of operation of the SARADC according to the fifth embodiment of the present technology.

### MODE FOR CARRYING OUT THE INVENTION

Modes for carrying out the present technology (hereinafter, referred to as embodiments) will be described below. The description will be given in the following order.
1. First embodiment (example in which two systems of DACs are connected in parallel)
2. Second embodiment (example in which two systems of DACs are connected in parallel, and single-ended to differential conversion is performed after sampling)
3. Third embodiment (example in which two systems of DACs are connected in parallel and configured for single-ended input)
4. Fourth embodiment (example in which two systems of DACs are connected in parallel, and enable switches on the input side of a comparison unit are removed)
5. Fifth embodiment (example in which three systems of DACs are connected in parallel)

### <1. First embodiment>

### [Configuration example of imaging device]

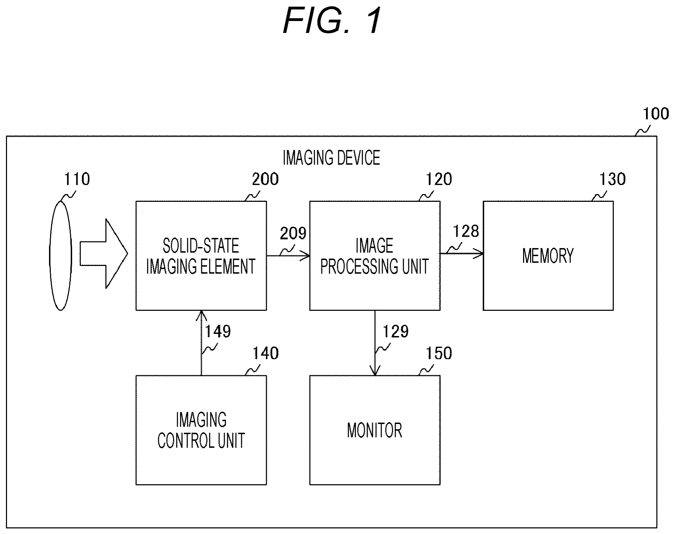

Fig. 1 is a block diagram illustrating a configuration example of an imaging device 100 according to a first embodiment of the present technology. The imaging device 100 is a device that captures image data, and includes an optical system 110, a solid-state imaging element 200, an image processing unit 120, a memory 130, an imaging control unit 140, and a monitor 150. Possible examples of the imaging device 100 include an Internet of Things (IoT) camera, an in-vehicle camera, and the like.

The optical system 110 collects light from a subject, and guides the light to the solid-state imaging element 200. The optical system 110 includes at least one optical lens.

The solid-state imaging element 200 captures image data under the control of the imaging control unit 140. The solid-state imaging element 200 supplies the captured image data to the image processing unit 120 via a signal line 209.

The imaging control unit 140 controls the solid-state imaging element 200. The imaging control unit 140 supplies the solid-state imaging element 200 with signals such as a vertical synchronization signal indicating image capture timing and a signal for controlling exposure time via a signal line 149. Furthermore, the imaging control unit 140 starts supplying the vertical synchronization signal, for example, when an operation to start image capture (such as pressing a shutter button) is performed.

The image processing unit 120 performs predetermined image processing such as demosaicing and white balance adjustment on the image data. The image processing unit 120 supplies the processed image data to the memory 130 and the monitor 150 via signal lines 128 and 129. The memory 130 stores the image data. The monitor 150 displays the image data.

### [Configuration example of solid-state imaging element]

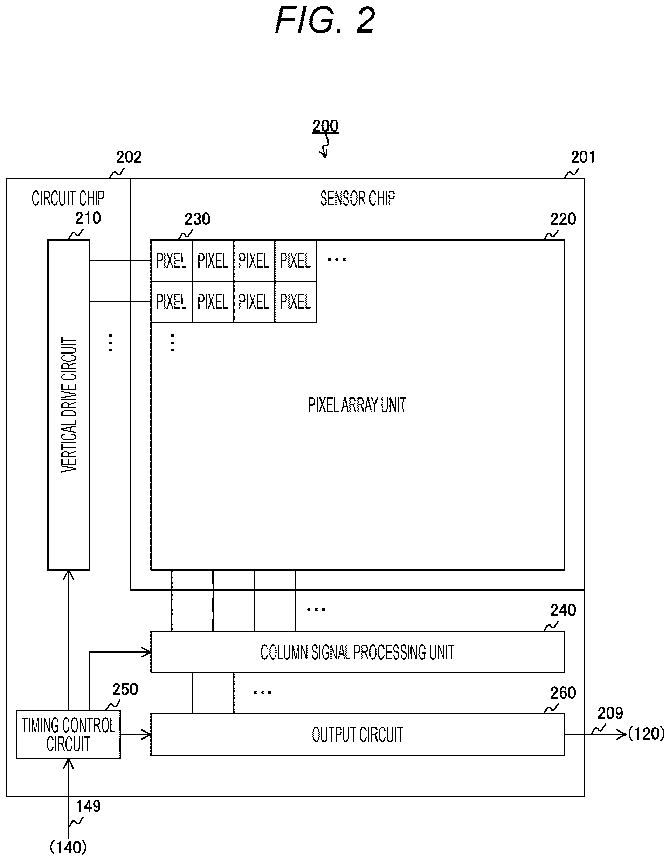

Fig. 2 is a block diagram illustrating a configuration example of the solid-state imaging element 200 according to the first embodiment of the present technology. The solid-state imaging element 200 includes a sensor chip 201 and a circuit chip 202 stacked on the sensor chip 201.

In the sensor chip 201, a pixel array unit 220 is arranged, the pixel array unit 220 including a plurality of pixels 230 arranged in a two-dimensional grid pattern. Furthermore, in the circuit chip 202, a vertical drive circuit 210, a column signal processing unit 240, a timing control circuit 250, and an output circuit 260 are arranged.

The vertical drive circuit 210 drives the pixel 230 to output a pixel signal to the column signal processing unit 240. The column signal processing unit 240 performs AD conversion processing on the pixel signal for each column and supplies the resultant data to the output circuit 260. The output circuit 260 performs correlated double sampling (CDS) processing and the like on the data received from the column signal processing unit 240, and outputs the resultant data to the image processing unit 120. Furthermore, in the output circuit 260, in addition to the CDS processing, auto focus (AF) processing for detecting focus on the basis of the contrast of the image data is performed, as necessary.

The timing control circuit 250 controls operation timing of each of the vertical drive circuit 210, the column signal processing unit 240, and the output circuit 260 in synchronization with the vertical synchronization signal.

Note that, in the solid-state imaging element 200, the above-described circuits are arranged on the two stacked chips, but the present technology is not limited to such a configuration, and the circuits can be arranged on a single semiconductor chip.

### [Configuration example of pixel circuit]

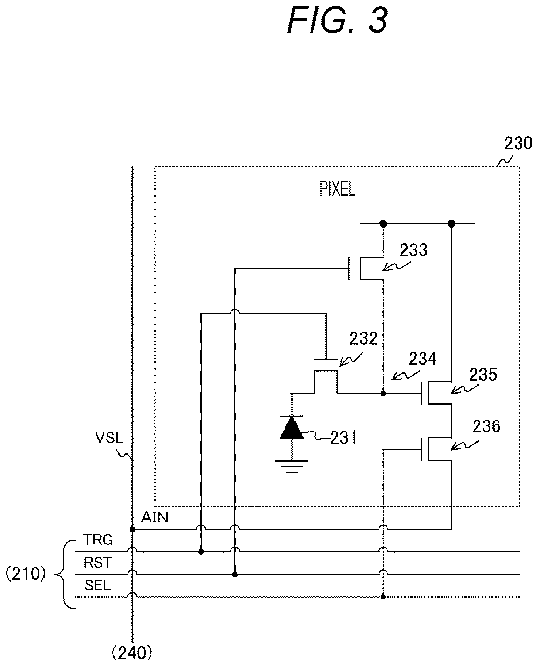

Fig. 3 is a circuit diagram illustrating a configuration example of the pixel 230 according to the first embodiment of the present technology. The pixel 230 includes a photodiode 231, a transfer transistor 232, a reset transistor 233, a floating diffusion layer 234, an amplification transistor 235, and a selection transistor 236.

The photodiode 231 photoelectrically converts received light into charge. The photodiode 231 is arranged on the back surface of a semiconductor substrate, opposite the front surface on which the circuits are arranged. Such a solid-state imaging element is referred to as a back-illuminated solid-state imaging element. Note that, instead of the back-illuminated configuration, a front-illuminated configuration in which the photodiode 231 is arranged on the front surface can also be employed.

The transfer transistor 232 transfers charge from the photodiode 231 to the floating diffusion layer 234 in accordance with a transfer signal TRG received from the vertical drive circuit 210. The floating diffusion layer 234 accumulates the transferred charge and generates a voltage corresponding to the level of accumulated charge.

The reset transistor 233 extracts the charge from the floating diffusion layer 234 to reset the charge level in accordance with a reset signal RST received from the vertical drive circuit 210. The amplification transistor 235 amplifies the voltage of the floating diffusion layer 234. The selection transistor 236 outputs a signal of the amplified voltage as a pixel signal AIN to the column signal processing unit 240 via a vertical signal line VSL in accordance with a selection signal SEL received from the vertical drive circuit 210.

Note that the circuit configuration of the pixel 230 is not limited to the configuration illustrated in the drawing as long as pixel signals can be generated through photoelectric conversion.

### [Configuration example of column signal processing unit]

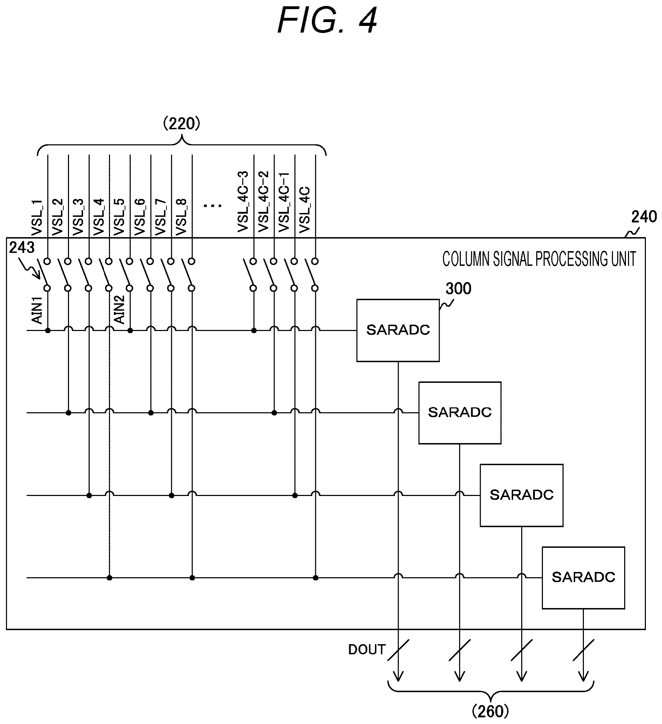

Fig. 4 is a block diagram illustrating a configuration example of the column signal processing unit 240 according to the first embodiment of the present technology. Furthermore, in the column signal processing unit 240, one SARADC 300 is arranged for each group of vertical signal lines. Assuming four SARADCs 300 and 4×C (where C is an integer) columns, each SARADC 300 is connected to C columns. Furthermore, the vertical signal line VSL is arranged for each column, and a switch 243 that opens and closes a path between the corresponding SARDC 300 and vertical signal line VSL is arranged for each column. For example, vertical signal lines VSL_1 and VSL_5 are connected to the first SARADC 300 via the switches 243.

Each time a row is selected, the vertical drive circuit 210, for example, causes the pixel signal AIN in the selected row to be output. The timing control circuit 250 inputs, to the SARADC 300, the corresponding VSL signal by controlling the corresponding four switches 243 to be in a closed state. A pixel signal input to the SARADC 300 at an odd-numbered position (for example, a signal from the vertical signal line VSL_1) is denoted as AIN1, and a pixel signal input at an even-numbered position (for example, a signal from the vertical signal line VSL_5) is denoted as AIN2. The SARADC 300 sequentially performs AD conversion on AIN1 and AIN2, and outputs the resultant signal to the output circuit 260 as a digital signal DOUT.

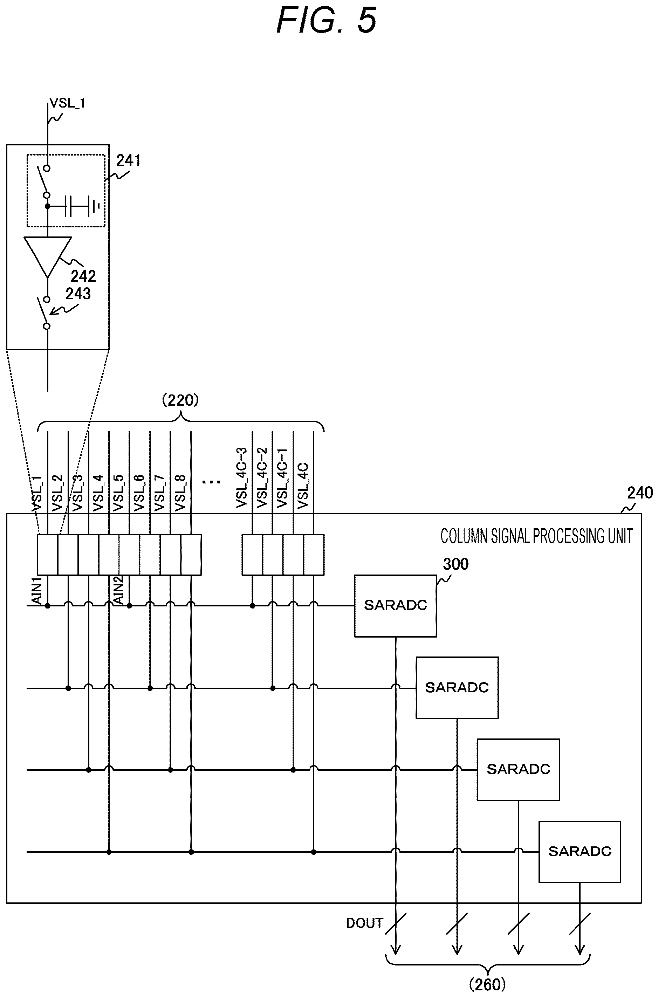

Note that although four SARADCs 300 are arranged in the drawing, the number of SARADCs 300 is arbitrary and is not limited to four. Furthermore, as illustrated in Fig. 5, a sample-and-hold circuit 241 and a column amplifier 242 can be further arranged for each column. In this case, the sample-and-hold circuit 241 samples and holds the pixel signal AIN received from the corresponding vertical signal line VSL, and the column amplifier 242 amplifies the pixel signal AIN received from the sample-and-hold circuit 241 and supplies the amplified pixel signal AIN to the switch 243.

### [Configuration example of SARADC]

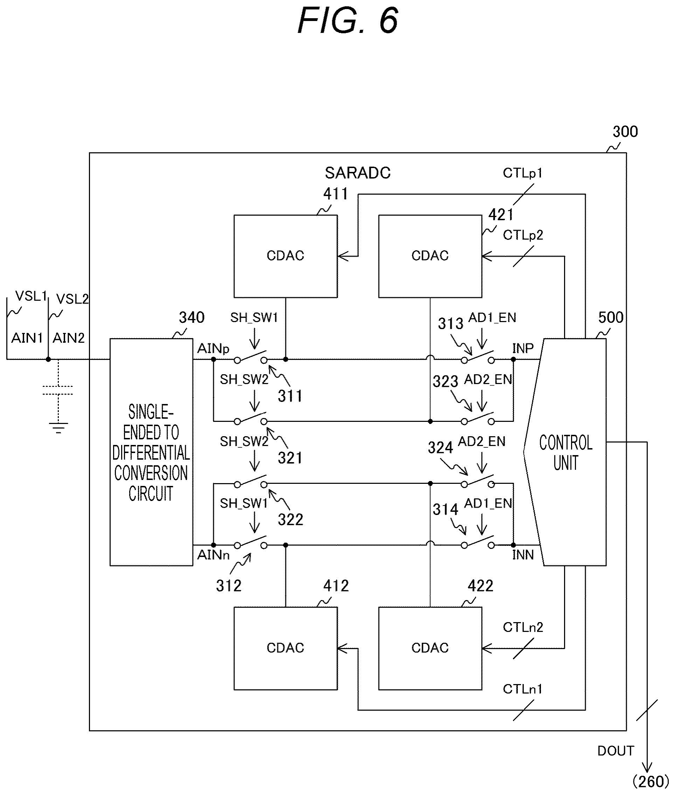

Fig. 6 is a block diagram illustrating a configuration example of the SARADC 300 according to the first embodiment of the present technology. The SARADC 300 includes a single-ended to differential conversion circuit 340, sample-and-hold switches 311, 312, 321, and 322, and enable switches 313, 314, 323, and 324. Moreover, the SARADC 300 further includes capacitor digital-to-analog converters (CDACs) 411, 412, 421, and 422, and a control unit 500. Note that the SARADC 300 is an example of an AD converter recited in the claims.

Hereinafter, the CDACs 411 and 412, and the control unit 500 for AD conversion of the pixel signal AIN1 are referred to as a "first system". Furthermore, the CDACs 421 and 422, and the control unit 500 for AD conversion of the pixel signal AIN2 are referred to as a "second system". The control unit 500 is shared between the first system and the second system.

The pixel signal AIN (AIN1 or AIN2), which is a single-ended signal, is input from the pixel array unit 220 to the single-ended to differential conversion circuit 340 via the vertical signal line VSL. The single-ended to differential conversion circuit 340 converts the pixel signal AIN into a differential signal. The differential signal contains a positive signal AINp and a negative signal AINn. The differential signal corresponding to AIN1 is denoted as AINp1 and AINn1, and the differential signal corresponding to AIN2 is denoted as AINp2 and AINn2. Furthermore, a capacitor indicated by a dotted line in the drawing indicates parasitic capacitance caused by the routing load of the vertical signal line VSL.

Note that the pixel signal AIN1 is an example of a first single-ended signal recited in the claims, and the pixel signal AIN2 is an example of a second single-ended signal recited in the claims.

The sample-and-hold switch 311 opens and closes a path between the single-ended to differential conversion circuit 340 and the CDAC 411 of the first system in accordance with a control signal SH_SW1 received from the timing control circuit 250. The control signal SH_SW1 is a signal indicating a sampling period of the first system, and for example, the control signal SH_SW1 is controlled to be at a high level during the sampling period. The sample-and-hold switch 311 inputs the positive signal AINp1 to the CDAC 411 as an input signal during the sampling period of the first system.

The sample-and-hold switch 312 opens and closes a path between the single-ended to differential conversion circuit 340 and the CDAC 412 of the first system in accordance with the control signal SH_SW1. The sample-and-hold switch 312 inputs the negative signal AINn1 to the CDAC 412 as an input signal during the sampling period of the first system.

The sample-and-hold switch 321 opens and closes a path between the single-ended to differential conversion circuit 340 and the CDAC 421 of the second system in accordance with a control signal SH_SW2 received from the timing control circuit 250. The control signal SH_SW2 is a signal indicating a sampling period of the second system, and for example, the control signal SH_SW2 is controlled to be at a high level during the sampling period. The sampling period of the second system does not overlap with the sampling period of the first system. The sample-and-hold switch 321 inputs the positive signal AINp2 to the CDAC 421 as an input signal during the sampling period of the second system.

The sample-and-hold switch 322 opens and closes a path between the single-ended to differential conversion circuit 340 and the CDAC 422 of the second system in accordance with the control signal SH_SW2. The sample-and-hold switch 322 inputs the negative signal AINn2 to the CDAC 422 as an input signal during the sampling period of the second system.

The CDACs 411, 412, 421, and 422 generate analog signals through digital-to-analog (DA) conversion, and also serve as capacitors that hold input signals.

The CDACs 411 and 412 hold the input signals AINp1 and AINn1 received from the sample-and-hold switches 311 and 312. Thereafter, AD conversion is performed on AIN1 by turning on the enable switches 313 and 314 corresponding to AD1_EN to cause the control unit 500 to perform a comparison operation, and providing control signals CTLp1 and CTLn1 based on the comparison result to the CDACs 411 and 421. The CDAC 411 outputs a positive signal INP1 of the differential signal, and the CDAC 412 outputs a negative signal INN1. The control signals CTLp1 and CTLn1 are digital signals, and INP1 and INN1 are analog signals.

Note that the CDACs 411 and 412 are examples of a first DAC recited in the claims. AINp1 and AINn1 are examples of a first input signal recited in the claims. INP1 and INN1 are examples of a pair of first analog signals recited in the claims. The control signals CTLp1 and CTLn1 are examples of a first control signal recited in the claims.

The CDACs 421 and 422 hold the input signals AINp2 and AINn2 received from the sample-and-hold switches 321 and 322. Thereafter, AD conversion is performed on the AIN2 by turning on the enable switches 323 and 324 corresponding to AD2_EN to cause the control unit 500 to perform a comparison operation, and providing control signals CTLp2 and CTLn2 based on the comparison result to the CDACs 421 and 422. The CDAC 421 outputs a positive signal INP2 of the differential signal, and the CDAC 422 outputs a negative signal INN2. The control signals CTLp2 and CTLn2 are digital signals, and INP2 and INN2 are analog signals.

Note that the CDACs 421 and 422 are examples of a second DAC recited in the claims. AINp2 and AINn2 are examples of a second input signal recited in the claims. INP2 and INN2 are examples of a pair of second analog signals recited in the claims. The control signals CTLp2 and CTLn2 are examples of a second control signal recited in the claims.

The enable switch 313 opens and closes a path between the CDAC 411 and the control unit 500 in accordance with the enable signal AD1_EN received from the timing control circuit 250. The enable signal AD1_EN indicates a period during which successive approximation is performed on the differential signal in the first system. For example, the enable signal AD1_EN is controlled to be at a high level during the sampling period of the second system to enable successive approximation in the first system during this period. The enable switch 313 allows the positive signal INP1 to be supplied from the CDAC 411 to the control unit 500 during the sampling period of the second system.

The enable switch 314 opens and closes a path between the CDAC 412 and the control unit 500 in accordance with the enable signal AD1_EN. The enable switch 314 allows the negative signal INN1 to be supplied from the CDAC 412 to the control unit 500 during the sampling period of the second system.

The enable switch 323 opens and closes a path between the CDAC 421 and the control unit 500 in accordance with the enable signal AD2_EN received from the timing control circuit 250. The enable signal AD2_EN indicates a period during which successive approximation is performed on the differential signal in the second system. For example, the enable signal AD2_EN is controlled to be at a high level during the sampling period of the first system to enable successive approximation in the second system during this period. The enable switch 323 allows the positive signal INP2 to be supplied from the CDAC 421 to the control unit 500 during the sampling period of the first system.

The enable switch 324 opens and closes a path between the CDAC 422 and the control unit 500 in accordance with the enable signal AD2_EN. The enable switch 324 allows the negative signal INN2 to be supplied from the CDAC 422 to the control unit 500 during the sampling period of the first system.

The control unit 500 compares the positive signal INP (INP1 or INP2) with the negative signal INN (INN1 or INN2), and controls the level of a reference signal on the basis of the comparison result. The control unit 500 generates the control signals CTLp1 and CTLn1 on the basis of the comparison result between the positive signal INP1 and the negative signal INP1, and supplies the control signals CTLp1 and CTLn1 to the CDACs 411 and 412. Furthermore, the control unit 500 generates the control signals CTLp2 and CTLn2 on the basis of the comparison result between the positive signal INP2 and the negative signal INP2, and supplies the control signals CTLp2 and CTLn2 to the CDACs 421 and 422.

As described above, the sampling period of the first system does not overlap with the sampling period of the second system, the successive approximation of the first system is performed during the sampling period of the second system, and the successive approximation of the second system is performed during the sampling period of the first system. Therefore, the CDACs 411 and 412 generate INP1 and INN1 during the sampling period of the second system on the basis of AINp1 and AINn1 held during the sampling period of the first system and the control signals CTLp1 and CTLn1.

On the other hand, the CDACs 421 and 422 generate INP2 and INN2 during the sampling period of the first system on the basis of AINp2 and AINn2 held during the sampling period of the second system and the control signals CTLp2 and CTLn2.

Furthermore, the control unit 500 generate the control signals CTLp2 and CTLn2 during the sampling period of the first system on the basis of the comparison result between INP2 and INN2 of the second system. Furthermore, the control unit 500 generate the control signals CTLp1 and CTLn1 during the sampling period of the second system on the basis of the comparison result between INP1 and INN1 of the first system.

Note that the SARADC 300 illustrated in the drawing can also be used in a circuit other than the solid-state imaging element 200, such as a communication circuit of an Internet of Things (IoT) system. However, in that case, an input signal error due to an error in switching timing between the sample-and-hold switch of the first system and the sample-and-hold switch of the second system may pose a problem. On the other hand, in a case where the SARADC 300 is used in the solid-state imaging element 200 such as a CMOS image sensor (CIS), the VSL signal does not have frequency-dependent characteristics, and thus the timing error does not pose a significant problem.

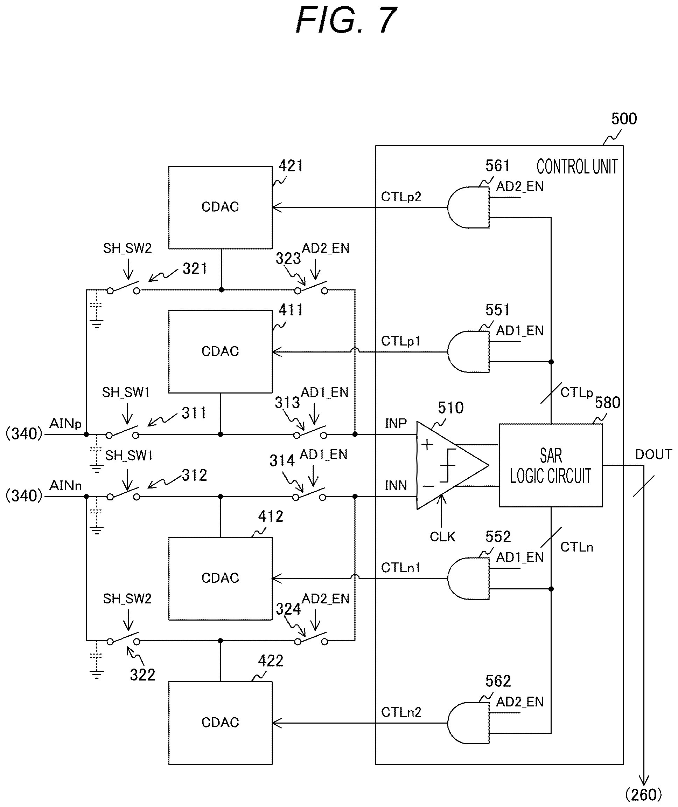

Fig. 7 is a block diagram illustrating a configuration example of the control unit 500 according to the first embodiment of the present technology. The control unit 500 includes a comparison unit 510, AND gates 551, 552, 561, and 562, and a SAR logic circuit 580.

The comparison unit 510 compares the positive signal INP (INP1 or INP2) with the negative signal INN (INN1 or INN2) in synchronization with a clock signal CLK, and supplies the comparison result to the SAR logic circuit 580.

The SAR logic circuit 580 stores the comparison result provided received from the comparison unit 510 and controls the level of the reference signal on the basis of the comparison result. The SAR logic circuit 580 updates, using a successive approximation method, the level of the reference signal so that the output of the CDAC 411(or CDAC421) and the output of the CDAC 412(or CDAC 422) are balanced. The SAR logic circuit 580 generates control signals CTLp and CTLn for updating and outputs the control signals CTLp and CTLn to each of the AND gates. Furthermore, assuming that the SARADC 300 has a resolution of M bits (where M is an integer), the successive approximations is performed M times. The SAR logic circuit 580 holds the M comparison results, and supplies a bit sequence including an array of bits indicating the comparison results to the output circuit as the digital signal DOUT.

Note that the SAR logic circuit 580 is an example of a logic circuit recited in the claims.

Assuming that the number of bits for each of the control signals CTLp and CTLn is K (where K is an integer), each of the AND gates 551, 552, 561, and 562 includes K instances. In the drawing, for the sake of convenience in description, AND gates corresponding to second and subsequent bits have been omitted.

The k-th (where k is an integer from 1 to K) AND gate 551 outputs a logical AND of the k-th bit of the control signal CTLp and the enable signal AD1_EN to the CDAC 411 as the k-th bit of CTLp1.

The k-th AND gate 552 outputs a logical AND of the k-th bit of the control signal CTLn and the enable signal AD1_EN to the CDAC 412 as the k-th bit of CTLn1.

The k-th AND gate 561 outputs a logical AND of the k-th bit of the control signal CTLp and the enable signal AD2_EN to the CDAC 421 as the k-th bit of CTLp2.

The k-th AND gate 562 outputs a logical AND of the k-th bit of the control signal CTLn and the enable signal AD2_EN to the CDAC 422 as the k-th bit of CTLn2.

### [Configuration example of comparison unit]

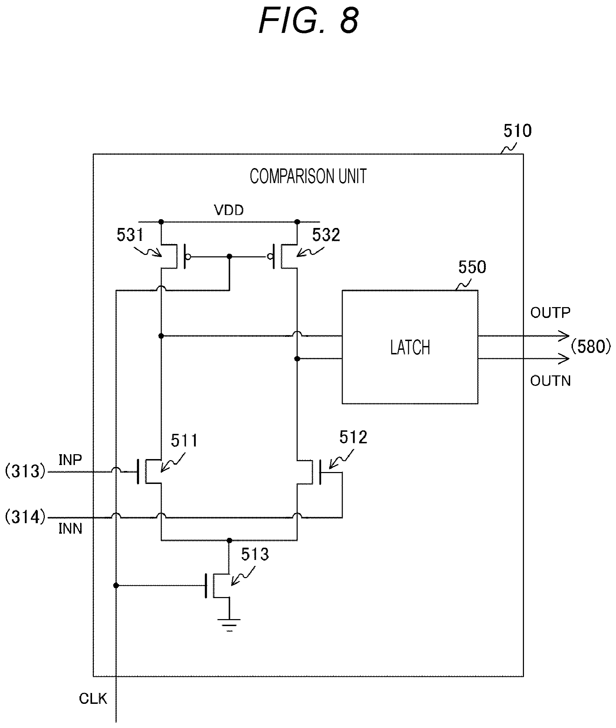

Fig. 8 is a block diagram illustrating a configuration example of the comparison unit 510 according to the first embodiment of the present technology. The comparison unit 510 includes p-channel metal oxide semiconductor (pMOS) transistors 531 and 532, n-channel MOS (nMOS) transistors 511, 512, and 513, and a latch 550.

The pMOS transistors 531 and 532 are connected in parallel with a node at power supply potential VDD.

The positive signal INP is input to the gate of the nMOS transistor 511, and the nMOS transistor 511 has its drain connected to the pMOS transistor 531. The negative signal INN is input to the gate of the nMOS transistor 512, and the nMOS transistor 512 has its drain connected to the pMOS transistor 532. The nMOS transistors 511 and 512 have their sources commonly connected to the nMOS transistor 513. The nMOS transistor 513 is inserted between a node commonly connected to the nMOS transistors 511 and 512 and a node at ground potential.

Furthermore, the clock signal CLK is input to the gates of the pMOS transistors 531 and 532 and the gate of the nMOS transistor 513.

A node connecting the pMOS transistor 531 and the nMOS transistor 511 is connected to a positive input terminal of the latch 550, and a node connecting the pMOS transistor 532 and the nMOS transistor 512 is connected to a negative input terminal of the latch 550. The latch 550 outputs, to the SAR logic circuit 580, output signals OUTP and OUTN indicating the comparison result of the input differential signal.

With the circuit configuration illustrated in the drawing, the positive signal INP and the negative signal INN are compared in synchronization with the clock signal CLK.

### [Operation example of SARADC]

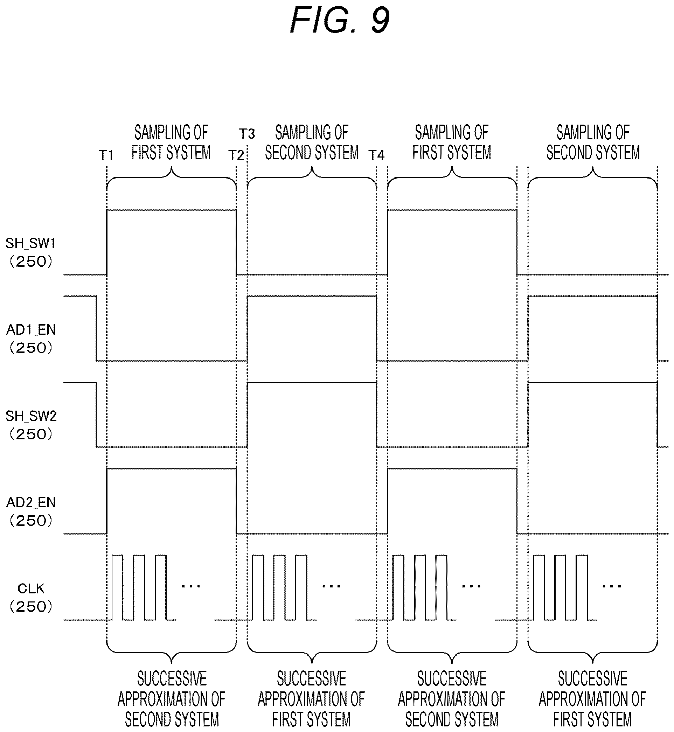

Fig. 9 is a timing chart illustrating an example of operation of the SARADC 300 according to the first embodiment of the present technology. The timing control circuit 250 sets the control signal SH_SW1 to a high level during the sampling period of the first system from timing T1 to timing T2. Furthermore, the timing control circuit 250 sets the enable signal AD2_EN to a high level during this period. On the other hand, the control signal SH_SW2 and the enable signal AD1_EN are controlled to be at a low level.

With this control, the CDACs 411 and 412 of the first system sample and hold the input signal. On the other hand, the comparison unit 510 performs the successive approximation of the second system in synchronization with the clock signal CLK. During this period, for example, the pixel signals of the vertical signal lines VSL_1 to VSL_4 are read out.

The timing control circuit 250 sets the control signal SH_SW2 to a high level during the sampling period of the second system from timing T3 immediately after timing T2 to timing T4. Furthermore, the timing control circuit 250 sets the enable signal AD1_EN to a high level during this period. On the other hand, the control signal SH_SW1 and the enable signal AD2_EN are controlled to be at a low level at timing T2.

With this control, the CDACs 421 and 422 of the second system sample and hold the input signal. On the other hand, the comparison unit 510 performs the successive approximation of the first system in synchronization with the clock signal CLK. During this period, for example, the pixel signals of the vertical signal lines VSL_5 to VSL_8 are read out.

Similarly, after timing T4, the sampling of the first system and the sampling of the second system are alternately performed. Furthermore, the successive approximation of the second system is performed during the sampling period of the first system, and the successive approximation of the first system is performed during the sampling period of the second system.

Here, assume a configuration in which only one CDAC system is provided as a first comparative example.

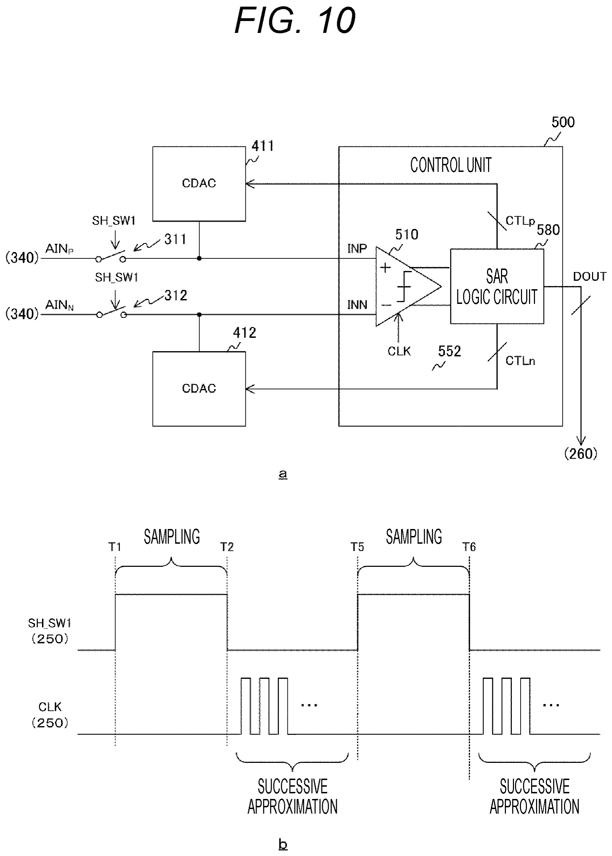

Fig. 10 illustrates examples of a block diagram and timing chart of the SARADC according to the first comparative example. Of the drawing, a is a block diagram illustrating a configuration example of the SARADC according to the first comparative example, and b is a timing chart illustrating an example of operation of the SARADC according to the first comparative example.

As illustrated in a of the drawing, in the first comparative example, only one system including CDACs 411 and 412 is arranged.

In this case, as illustrated in b of the drawing, sampling and successive approximation are alternately performed. For example, the input signal is sampled by the CDACs 411 and 412 during the sampling period from timing T1 to timing T2. Then, the successive approximation is performed during the period from timing T2 to timing T5. Subsequently, the next input signal is sampled by the CDACs 411 and 412 during the sampling period from timing T5 to timing T6. Then, the successive approximation is performed after timing T6.

As illustrated in b of the drawing, in the first comparative example based on the single CDAC system, during a sampling period of the pixel signal of a certain column, AD conversion cannot be performed on the pixel signal of another column. On the other hand, in the first embodiment, while the first system samples the pixel signal of a certain column, the second system can perform AD conversion on the pixel signal of another column. This enables faster AD conversion than in the first comparative example.

Furthermore, in the first comparative example, the block that operates in the sampling phase and the block that operates in the successive approximation phase are different, leading to a variation in IR drop. This variation may cause different effects on the peripheral circuits, which may lead to increased streaking. On the other hand, in the first embodiment, the sampling block and the successive approximation block operate simultaneously, which prevents a variation in IR drop and allows a reduction in streaking.

Next, a configuration using the time-interleaved method in which a plurality of SARADCs is arranged in an AD converter and sampling is performed at different time instants is considered a second comparative example.

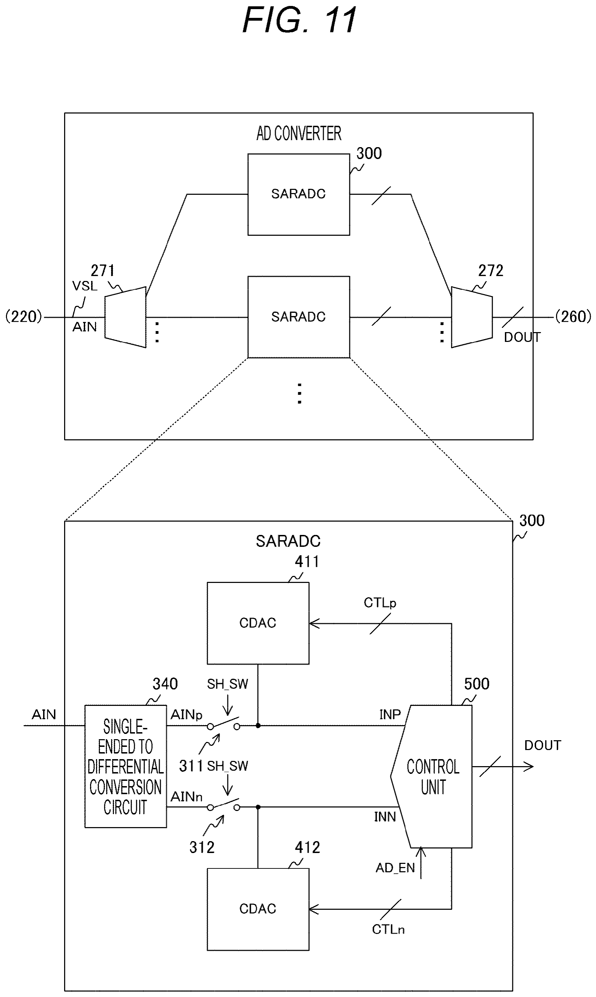

Fig. 11 is a block diagram illustrating a configuration example of an AD converter according to the second comparative example. In the second comparative example, at least two SARADCs and switching circuits 271 and 272 are arranged in the AD converter.

The switching circuit 271 selects one of the plurality of SARADCs 300 and connects the input terminal of the selected SARADC 300 to the vertical signal line VSL. The switching circuit 272 selects one of the plurality of SARADCs 300 and connects the output terminal of the selected SARADC 300 to the output circuit 260.

Each of the SARADCs 300 includes the single-ended to differential conversion circuit 340, the sample-and-hold switches 311 and 312, the CDACs 411 and 412, and the control unit 500. In the control unit 500, the comparison unit 510 and the SAR logic circuit 580 are arranged.

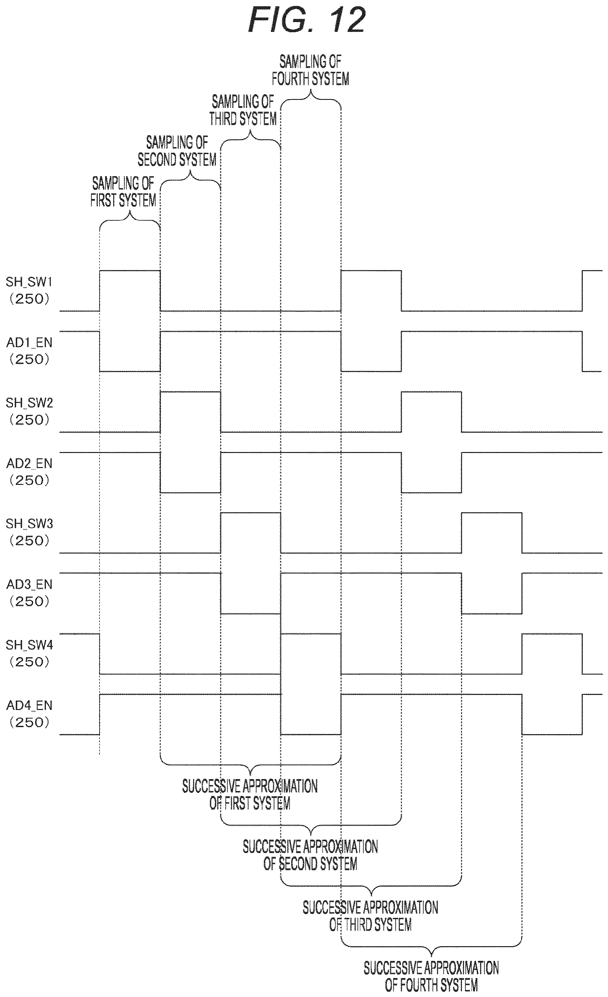

Fig. 12 is a timing chart illustrating an example of operation of the AD converter according to the second comparative example. As illustrated in the drawing, the plurality of SARADCs 300 performs the sampling at different time instants and performs the successive approximation after the sampling. For example, in a case of four systems, the sampling periods of each system differ by one-fourth of the period of the control signal SH_SW for sampling.

According to the time-interleaved method illustrated in the drawing, during sampling of the pixel signal of a certain column, the AD converter can perform AD conversion on the pixel signal of another column. This enables faster AD conversion than in the first comparative example. However, it is required that not only the CDAC but also the comparison unit 510 and the SAR logic circuit 580 be arranged in each SARADC 300, leading to an increase in circuit size. For example, a configuration in which the SARADC 300 includes two systems requires four CDACs, two comparison units, and two SAR logic circuits.

On the other hand, in the first embodiment, to connect the two systems of CDACs in parallel with the comparison unit 510, it is only required that four CDACs, one comparison unit, and one SAR logic circuit be arranged. This allows suppression of an increase in circuit size, compared to the second comparative example.

### [Operation example of solid-state imaging element]

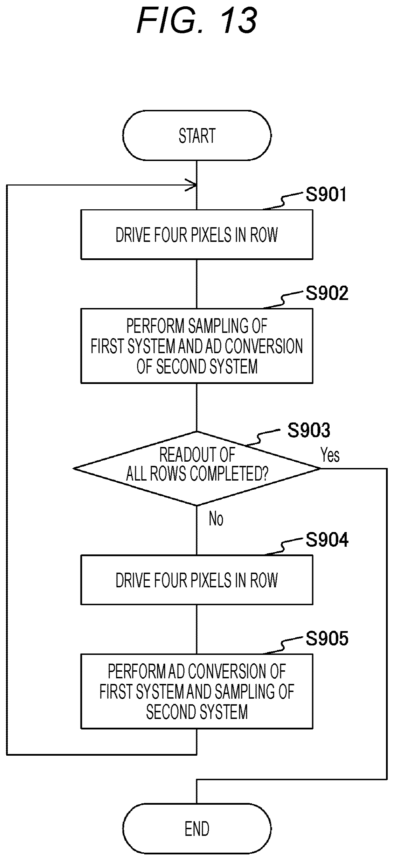

Fig. 13 is a flowchart illustrating an example of operation of the solid-state imaging element 200 according to the first embodiment of the present technology. The operation starts, for example, upon execution of a predetermined application for capturing image data.

The vertical drive circuit 210 selects a row. The column signal processing unit 240 drives four pixels in the row to output pixel signals (step S901). The first system of each of the four SARADCs 300 samples the pixel signals for the four pixels, and the second system performs AD conversion on the pixel signals for the preceding four pixels (step S902). Note that, when driving the first four pixels, there are no preceding four pixels, and thus only sampling is performed in step S902. When driving the last four pixels, only AD conversion is performed in step S902.

The solid-state imaging element 200 determines whether or not the readout of all rows has been completed (step S903). In a case where the readout of all the rows has been completed in the solid-state imaging element 200 (step S903: Yes), the solid-state imaging element 200 performs various types of image processing, as necessary, and ends the imaging processing.

On the other hand, in a case where the readout of all the rows has not been completed (step S903: No), the timing control circuit 250 drives next four pixels using the switches 243 and outputs pixel signals (step S904). The first system performs AD conversion on the sampled pixel signals, and the second system samples the newly output pixel signals (step S905).

Then, step S901 and subsequent steps are repeated.

Note that, in a case where a plurality of pieces of image data is continuously captured, steps S901 to S905 are repeated in synchronization with the vertical synchronization signal.

As described above, according to the first embodiment of the present technology, the CDACs 411 and 412 of the first system and the CDACs 421 and 422 of the second system are connected in parallel with the comparison unit 510, allowing suppression of an increase in circuit size, compared to the second comparative example. Furthermore, the first system holds the input signal during the first sampling period, and the second system holds the input signal during the first sampling period, enabling faster AD conversion than in the first comparative example.

### <2. Second embodiment>

In the first embodiment described above, the SARADC 300 converts a single-ended signal into a differential signal before sampling. An SARADC 300 according to the second embodiment is different from that according to the first embodiment in that a single-ended signal is converted into a differential signal after sampling.

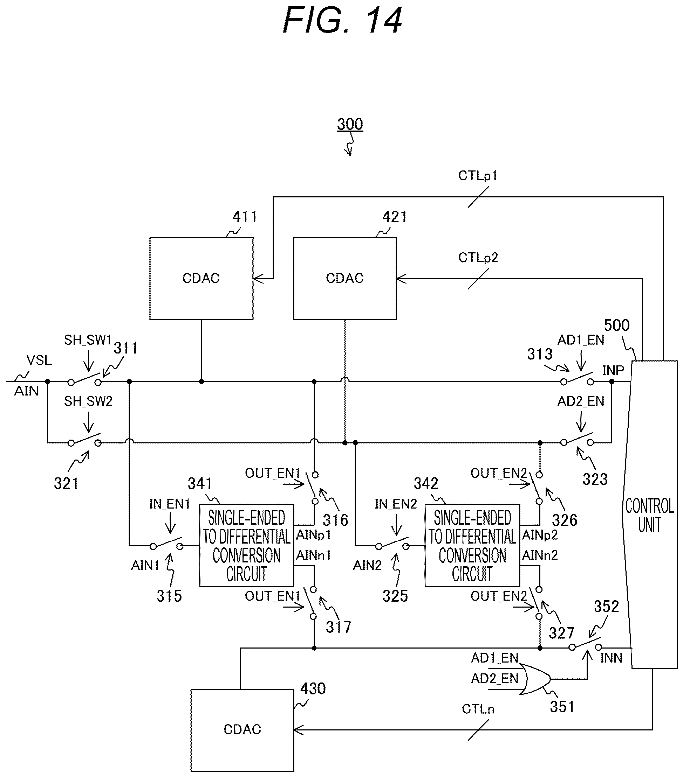

Fig. 14 is a block diagram illustrating a configuration example of the SARADC 300 according to the second embodiment of the present technology. In the SARADC 300 according to the second embodiment, single-ended to differential conversion circuits 341 and 342 are provided instead of the single-ended to differential conversion circuit 340. Furthermore, instead of the CDACs 412 and 422, a CDAC 430 is provided. Furthermore, the sample-and-hold switches 312 and 322 and the enable switches 314 and 324 are removed, and enable switches 315, 316, 317, 325, 326, and 327 are added. Furthermore, an OR (logical OR) gate 351 and an enable switch 352 are added.

The CDAC 430 is shared between the first system and the second system. Note that the CDAC 430 is an example of a shared DAC recited in the claims.

The sample-and-hold switches 311 and 321 have their input terminals commonly connected to a plurality of corresponding vertical signal lines VSL (such as VSL_1 and VSL_5) via the switches 243. The sample-and-hold switch 311 of the first system supplies a pixel signal (single-ended signal) AIN1 from the vertical signal line VSL to the CDAC 411 in accordance with the control signal SH_SW1. The CDAC 411 holds the pixel signal AIN1. Note that the pixel signal AIN1 is an example of the first single-ended signal recited in the claims.

The enable switch 315 of the first system supplies the pixel signal AIN1 held by the CDAC 411 to the single-ended to differential conversion circuit 341 while an enable signal IN_EN1 received from the timing control circuit 250 is at a high level.

The single-ended to differential conversion circuit 341 of the first system converts the pixel signal AIN1 of the first system into a differential signal containing AINp1 and AINn1, and supplies the differential signal to the enable switches 316 and 317. Note that the single-ended to differential conversion circuit 341 is an example of a first single-ended to differential conversion circuit recited in the claims.

The enable switch 316 of the first system supplies a positive signal AINp1 to the CDAC 411 while an enable signal OUT_EN1 received from the timing control circuit 250 is at a high level. The enable switch 317 of the first system supplies a negative signal AINn1 to the CDAC 430 while an enable signal EN1_OUT1 is at a high level.

The CDAC 411 of the first system holds the positive signal AINp1 of the first system, generates a positive signal INP1 on the basis of the positive signal AINp1 and a control signal CTLp1 received from the control unit 500, and supplies the positive signal INP1 to the enable switch 313. The CDAC 430 holds the negative signal AINn1 of the first system, generates a negative signal INN on the basis of the negative signal AINn1 and a control signal CTLn received from the control unit 500, and supplies the negative signal INN to the enable switch 352.

The enable switch 313 of the first system supplies the positive signal INP1 from the CDAC 411 to the control unit 500 while an enable signal AD1_EN is at a high level.

On the other hand, the sample-and-hold switch 321 of the second system supplies a pixel signal (single-ended signal) AIN2 from the vertical signal line VSL to the CDAC 421 in accordance with a control signal SH_SW2. The CDAC 421 holds the pixel signal AIN2. Note that the pixel signal AIN2 is an example of the second single-ended signal recited in the claims.

The enable switch 325 of the second system supplies the pixel signal AIN2 held by the CDAC 421 to the single-ended to differential conversion circuit 342 while an enable signal IN_EN2 received from the timing control circuit 250 is at a high level.

The single-ended to differential conversion circuit 342 of the second system converts the pixel signal AIN2 of the second system into a differential signal containing AINp2 and AINn2, and supplies the differential signal to the enable switches 326 and 327. Note that the single-ended to differential conversion circuit 342 is an example of a second single-ended to differential conversion circuit recited in the claims.

The enable switch 326 of the second system supplies the positive signal AINp2 to the CDAC 421 while an enable signal OUT_EN2 received from the timing control circuit 250 is at a high level. The enable switch 327 of the second system supplies the negative signal AINn2 to the CDAC 430 while an enable signal EN_OUT2 is at a high level.

The CDAC 421 of the second system holds the positive signal AINp2 of the second system, generates a positive signal INP2 on the basis of the positive signal AINp2 and a control signal CTLp2 received from the control unit 500, and supplies the positive signal INP2 to the enable switch 323. The CDAC 430 holds the negative signal AINn2 of the second system, generates the negative signal INN on the basis of the negative signal AINn2 and the control signal CTLn from the control unit 500, and supplies the negative signal INN to the enable switch 352.

The enable switch 323 of the second system supplies the positive signal INP2 from the CDAC 421 to the control unit 500 while an enable signal AD2_EN is at a high level.

The OR gate 351 outputs a logical OR of the enable signals AD1_EN and AD2_EN to the enable switch 352. The enable switch 352 supplies the negative signal INN from the CDAC 430 to the control unit 500 while the signal received from the OR gate 351 is at a high level.

Note that, in the drawing, the first system and the second system share the CDAC on the negative side, but the CDACs of the first system and the second system can be arranged on the negative side, and the first system and the second system can share a single CDAC on the positive side.

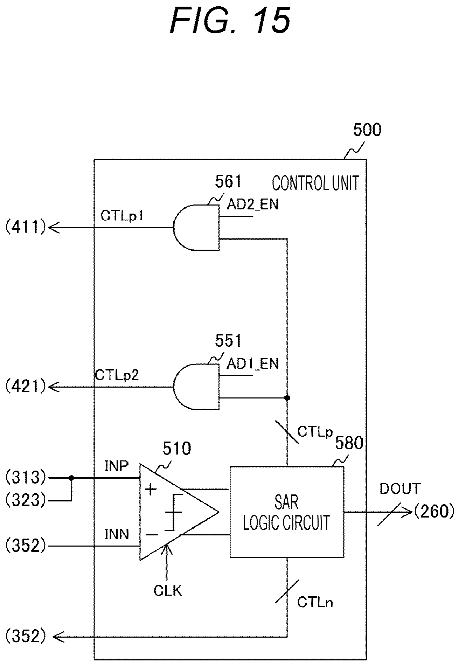

Fig. 15 is a block diagram illustrating a configuration example of the control unit 500 according to the second embodiment of the present technology. In the control unit 500 of the second embodiment, the AND gates 552 and 562 on the negative side are removed.

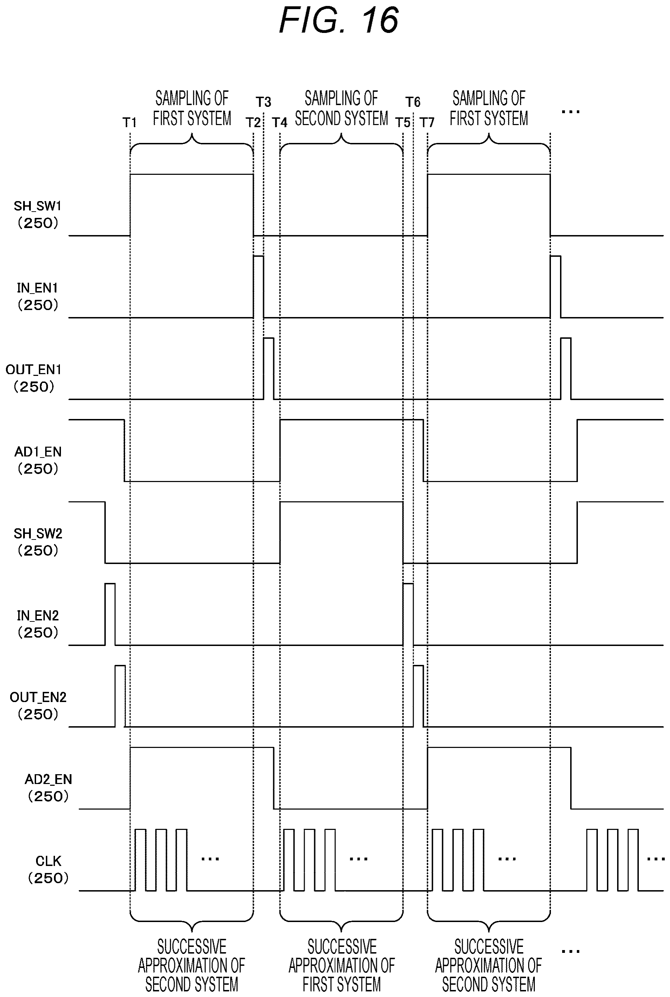

Fig. 16 is a timing chart illustrating an example of operation of the SARADC 300 according to the second embodiment of the present technology. The timing control circuit 250 sets the control signal SH_SW1 to a high level during the sampling period of the first system from timing T1 to timing T2. As a result, the sampling of the first system is performed. Furthermore, the timing control circuit 250 sets the enable signal AD2_EN to a high level during a period from timing T1 to immediately before timing T4. Within this period, the successive approximation of the second system is performed during the sampling period of the first system.

Furthermore, the timing control circuit 250 sets the enable signal IN_EN1 to a high level over the pulse period from timing T2, and sets the enable signal OUT_EN1 to a high level over the pulse period from timing T3. As a result, the single-ended signal of the first system is converted into a differential signal and output.

Then, the timing control circuit 250 sets the control signal SH_SW2 to a high level during the sampling period of the second system from timing T4 to timing T5. As a result, the sampling of the second system is performed. Furthermore, the timing control circuit 250 sets the enable signal AD1_EN to a high level during a period from timing T4 to immediately before timing T7. Within this period, the successive approximation of the first system is performed during the sampling period of the second system.

Furthermore, the timing control circuit 250 sets the enable signal IN_EN2 to a high level over the pulse period from timing T5, and sets the enable signal OUT_EN2 to a high level over the pulse period from timing T6. As a result, the single-ended signal of the second system is converted into a differential signal and output.

As illustrated in the drawing, the single-ended to differential conversion of the first system is performed in the interval between the end of the sampling period of the first system and the start of the sampling period of the second system. Furthermore, as illustrated in the drawing, the single-ended to differential conversion of the second system is performed in the interval between the end of the sampling period of the second system and the start of the sampling period of the first system. As described above, by allowing the single-ended to differential conversion to be performed at timing outside the sampling period, the number of CDACs on the negative side can be reduced to one as illustrated in Fig. 14.

As described above, according to the second embodiment of the present technology, the single-ended to differential conversion circuits 341 and 342 convert a single-ended signal into a differential signal after sampling, allowing a reduction in circuit size by reducing the number of CDACs on the negative side to one.

### <3. Third embodiment>

In the first embodiment described above, the SARADC 300 converts a single-ended signal into a differential signal before sampling, but with this configuration, it is difficult to further reduce the circuit size. A SARADC 300 according to the third embodiment is different from that according to the first embodiment in that a single-ended signal is held without being converted into a differential signal.

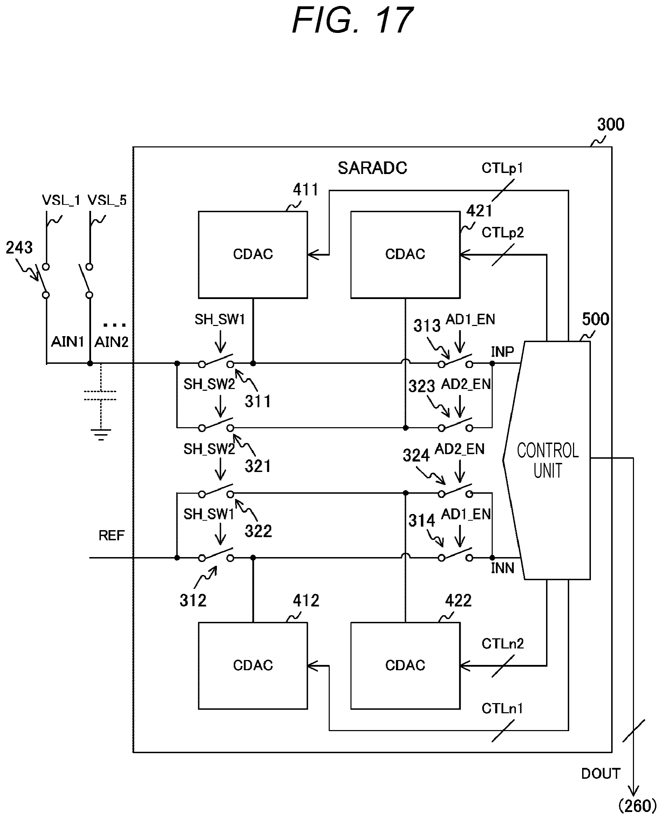

Fig. 17 is a block diagram illustrating a configuration example of the SARADC 300 according to the third embodiment of the present technology. The SARADC 300 according to the third embodiment is different from that according to the first embodiment in that the single-ended to differential conversion circuit 340 is not arranged.

Furthermore, the sample-and-hold switches 311 and 321 have their input terminals commonly connected to a plurality of corresponding vertical signal lines (such as VSL_1 and VSL_5) via the switches 243. The sample-and-hold switch 311 supplies a pixel signal (single-ended signal) AIN1 to the CDAC 411 of the first system in accordance with a control signal SH_SW1. The sample-and-hold switch 321 supplies a pixel signal (single-ended signal) AIN2 to the CDAC 421 of the second system in accordance with a control signal SH_SW2.

Furthermore, a reference signal REF, which is a constant single-ended signal, is input to the input terminals of the sample-and-hold switches 312 and 322. The reference signal REF is generated by a base reference signal generation circuit (not illustrated) such as a DAC. The sample-and-hold switch 312 supplies the reference signal REF (single-ended signal) to the CDAC 412 of the first system in accordance with the control signal SH_SW1. The sample-and-hold switch 322 supplies the reference signal REF to the CDAC 422 of the second system in accordance with the control signal SH_SW2.

As illustrated in the drawing, the sample-and-hold switches 311 and 312 supply the pixel signal AIN1 and the reference signal REF to the first system, and the sample-and-hold switches 321 and 322 supply the pixel signal AIN2 and the reference signal REF to the second system. With this control, the single-ended to differential conversion circuit 340 can be removed.

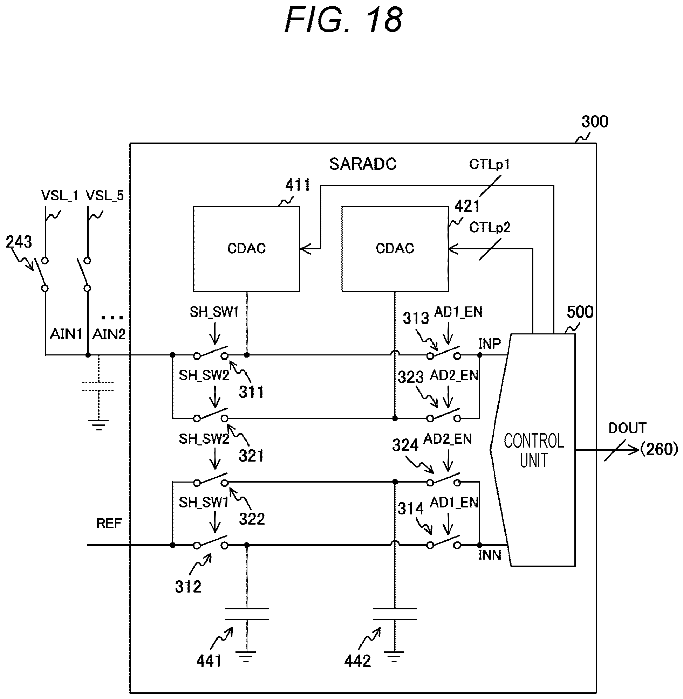

Note that, as illustrated in Fig. 18, the CDACs on the negative side can also be replaced with capacitors 441 and 442. In the drawing, the CDACs on the negative side are replaced with the capacitors 441 and 442, or alternatively, the VDACs on the positive side can be replaced.

As described above, according to the third embodiment of the present technology, the sample-and-hold switches 311, 312, 321, and 322 supply the pixel signals corresponding to each system and the reference signal REF, allowing the single-ended to differential conversion circuit 340 to be removed.

### <4. Fourth embodiment>

In the first embodiment described above, the enable switches 313, 314, 323, and 324 are inserted on the input side of the comparison unit 510, but when these switches are controlled, the on-resistance introduces corresponding noise. An SARADC 300 according to the fourth embodiment is different from that according to the first embodiment in that noise is reduced by removing the switches on the input side of the comparison unit 510.

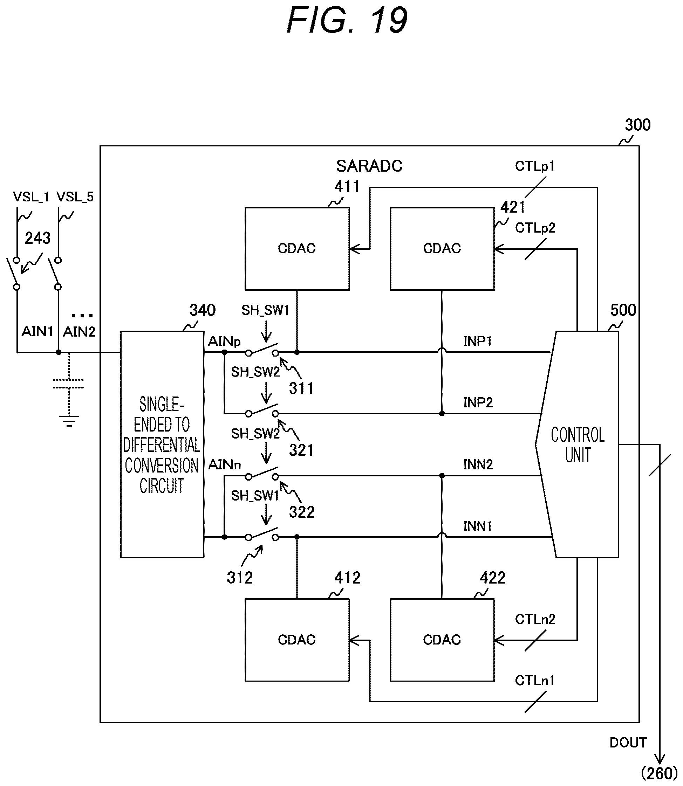

Fig. 19 is a block diagram illustrating a configuration example of the SARADC 300 according to the fourth embodiment of the present technology. The SARADC 300 according to the fourth embodiment is different from that according to the first embodiment in that the enable switches 313, 314, 323, and 324 are removed.

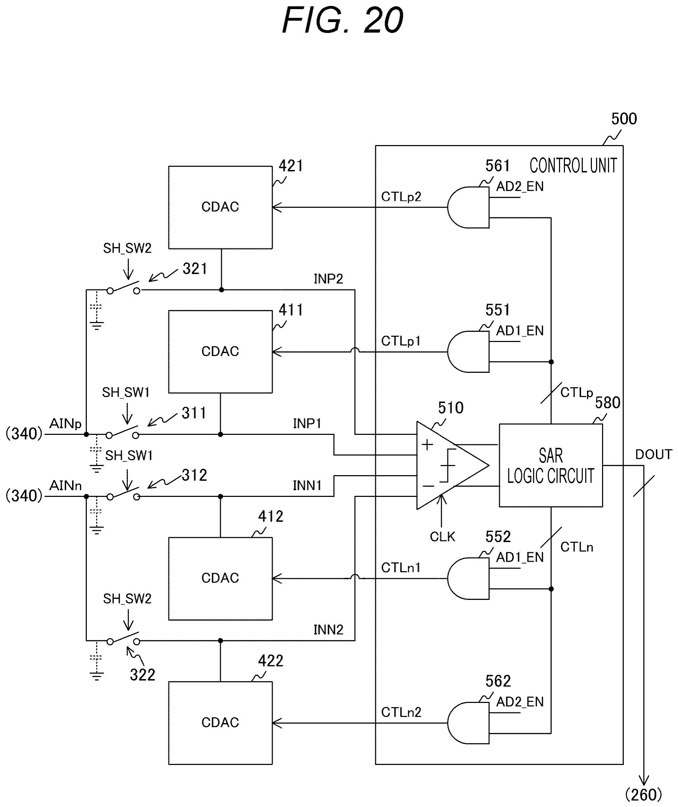

Fig. 20 is a block diagram illustrating a configuration example of the control unit 500 according to the fourth embodiment of the present technology. As illustrated in the drawing, INP1, INN1, INP2, and INN2 from the CDACs 411, 412, 421, and 422 are input to the comparison unit 510 in the control unit 500.

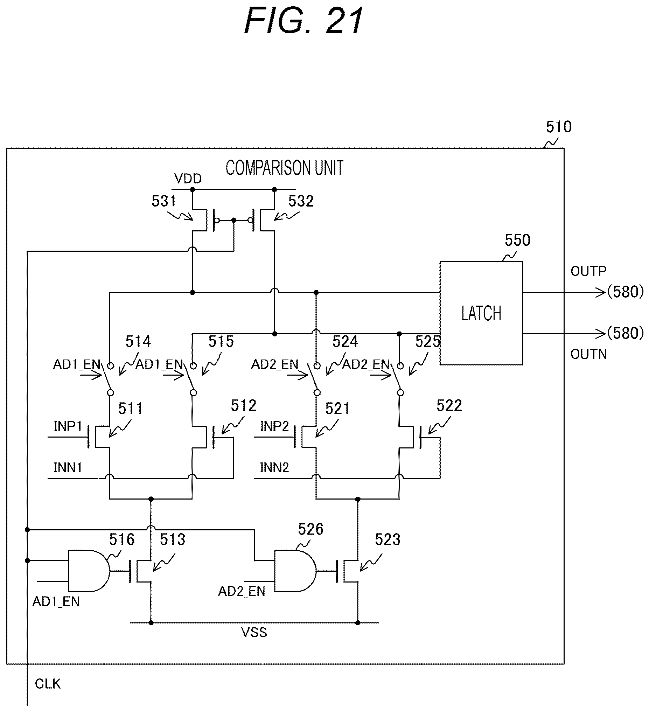

Fig. 21 is a circuit diagram illustrating a configuration example of the comparison unit 510 according to the fourth embodiment of the present technology. The comparison unit 510 according to the fourth embodiment further includes enable switches 514, 515, 524, and 525, nMOS transistors 521, 522, and 523, and AND gates 516 and 526.

The enable switch 514 opens and closes a path between the pMOS transistor 531 and the nMOS transistor 511 in accordance with an enable signal AD1_EN. The enable switch 514 transitions to a closed state in a case where the enable signal AD1_EN is at a high level. The enable switch 515 opens and closes a path between the pMOS transistor 532 and the nMOS transistor 512 in accordance with the enable signal AD1_EN. The enable switch 515 transitions to a closed state in a case where the enable signal AD1_EN is at a high level.

Furthermore, the connection point between the pMOS transistor 531 and the enable switch 514 and the connection point between the pMOS transistor 532 and the enable switch 515 are connected to the positive and negative input terminals of the latch 550.

The AND gate 516 supplies a logical AND of a clock signal CLK and the enable signal AD1_EN to the gate of the nMOS transistor 513.

The connection configuration of the nMOS transistors 521, 522, and 523 is similar to that of the nMOS transistors 511, 512, and 513.

The enable switch 524 opens and closes a path between the pMOS transistor 531 and the nMOS transistor 521 in accordance with an enable signal AD2_EN. The enable switch 524 transitions to a closed state in a case where the enable signal AD2_EN is at a high level. The enable switch 525 opens and closes a path between the pMOS transistor 532 and the nMOS transistor 522 in accordance with the enable signal AD2_EN. The enable switch 525 transitions to a closed state in a case where the enable signal AD2_EN is at a high level.

Furthermore, the connection point between the pMOS transistor 531 and the enable switch 524 and the connection point between the pMOS transistor 532 and the enable switch 525 are connected to the positive and negative input terminals of the latch 550.

The AND gate 526 supplies a logical AND of the clock signal CLK and the enable signal AD2_EN to the gate of the nMOS transistor 523.

As illustrated in the drawing, the comparison unit 510 selects and compares INP1 and INN1 or INP2 and INN2 in accordance with the enable signal. This allows the enable switch 313 and the like on the input side to be removed.

Note that the second or third embodiment can be applied to the fourth embodiment.

As described above, according to the fourth embodiment of the present technology, the enable switch 313 and the like on the input side of the comparison unit 510 are removed, allowing a reduction in the impact of noise resulting from the on-resistance of the switch.

### <5. Fifth embodiment>

In the first embodiment described above, two systems of CDACs are arranged in the SARADC 300, but with this configuration, the greater the parasitic capacitance caused by the routing load of the vertical signal line VSL, the longer the settling time becomes. The prolonged settling time increases the required sampling period, resulting in a decrease in AD conversion speed. An SARADC 300 according to the fifth embodiment is different from that according to the first embodiment in that a decrease in AD conversion speed is suppressed by arranging at least three systems of CDACs in the CDAC.

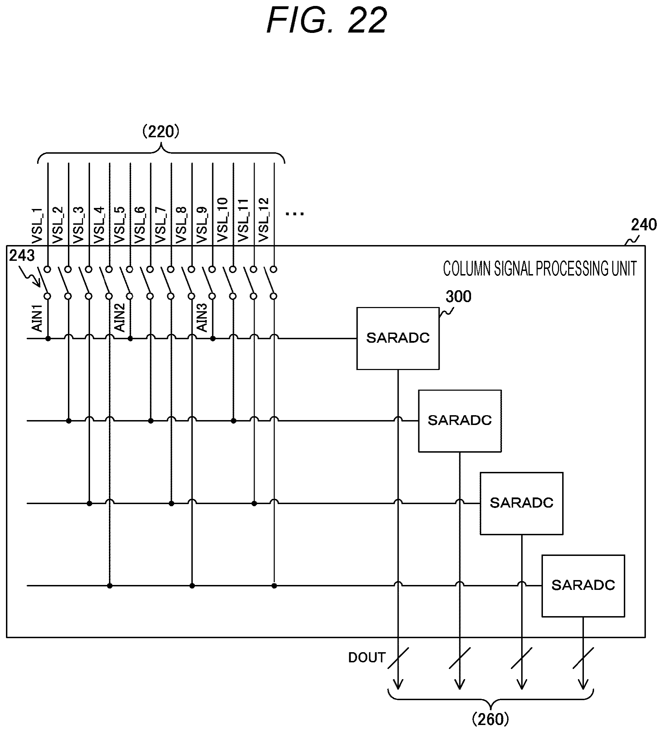

Fig. 22 is a block diagram illustrating a configuration example of the column signal processing unit 240 according to the fifth embodiment of the present technology. Also in this fifth embodiment, similar to the first embodiment, one SARADC 300 is arranged for each group of vertical signal lines.

Furthermore, each SARADC 300 is equipped with three systems of CDACs. C columns corresponding to each SARADC 300 are classified into first, second, and third groups. Assume that the pixel signal of the first group is denoted as AIN1, the pixel signal of the second group is denoted as AIN2, and the pixel signal of the third group is denoted as AIN3. For example, AIN1 is output from the vertical signal line VSL_1, AIN2 is output from the vertical signal line VSL_5, and AIN3 is output from the vertical signal line VSL_9.

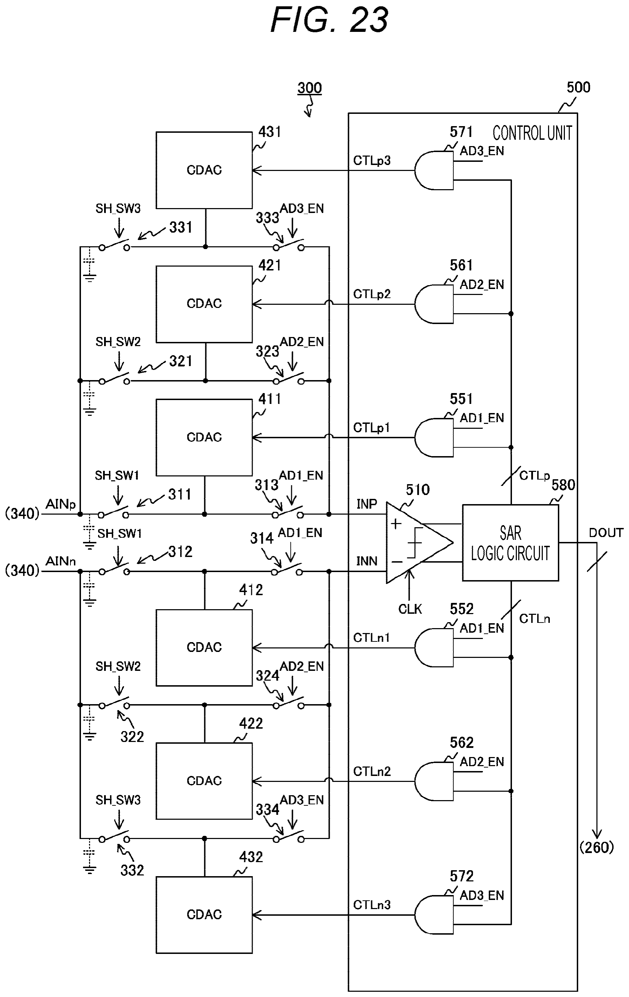

Fig. 23 is a block diagram illustrating a configuration example of the SARADC 300 according to the fifth embodiment of the present technology. The SARADC 300 according to the fifth embodiment is different from that according to the first embodiment in that the SARADC 300 further includes CDACs 431 and 432, sample-and-hold switches 331 and 332, and enable switches 333 and 334. Furthermore, the control unit 500 further includes AND gates 571 and 572. The CDACs 431 and 432 are referred to as CDACs of a "third system".

The single-ended to differential conversion circuit 340 converts the pixel signal AIN3 into a differential signal containing a positive signal AINp3 and a negative signal AINn3. The sample-and-hold switch 331 opens and closes a path between the single-ended to differential conversion circuit 340 and the CDAC 431 of the third system in accordance with a control signal SH_SW3 received from the timing control circuit 250. The control signal SH_SW3 is a signal indicating a sampling period of the third system, and for example, the control signal SH_SW3 is controlled to be at a high level during the sampling period. The sample-and-hold switch 331 inputs the positive signal AINp3 to the CDAC 431 as an input signal during the sampling period of the third system.

The sample-and-hold switch 332 opens and closes a path between the single-ended to differential conversion circuit 340 and the CDAC 432 of the third system in accordance with the control signal SH_SW3. The sample-and-hold switch 332 inputs the negative signal AINn3 to the CDAC 432 as an input signal during the sampling period of the third system.

The CDACs 431 and 432 hold the input signals AINp3 and AINn3 received from the sample-and-hold switches 331 and 332. Then, the CDACs 431 and 432 internally generate differential reference signals in accordance with control signals CTLp3 and CTLn3 received from the control unit 500, and differentially output differences between the reference signals and AINp3 and AINn3 to the enable switches 333 and 334. The CDAC 431 outputs a positive signal INP3 of the differential signal, and the CDAC 432 outputs a negative signal INN3. The control signals CTLp3 and CTLn3 are digital signals, and INP3 and INN3 are analog signals.

Note that the CDACs 431 and 432 are examples of a third digital-to-analog converter recited in the claims. AINp3 and AINn3 are examples of a third input signal recited in the claims.

The enable switch 333 opens and closes a path between the CDAC 431 and the control unit 500 in accordance with an enable signal AD3_EN received from the timing control circuit 250. The enable signal AD3_EN indicates a period during which successive approximation is performed on the differential signal in the third system. For example, the enable signal AD3_EN is controlled to be at a high level during a predetermined period within the sampling period of the first system to enable successive approximation of the third system. The enable switch 333 supplies the positive signal INP3 from the CDAC 431 to the control unit 500 while the enable signal AD3_EN is at a high level.

The enable switch 334 opens and closes a path between the CDAC 432 and the control unit 500 in accordance with the enable signal AD3_EN. The enable switch 334 supplies the negative signal INN3 from the CDAC 432 to the control unit 500 while the enable signal AD3_EN is at a high level.

Assuming that the control signals CTLp3 and CTLn3 each have K bits, each of the AND gates 571 and 572 includes K instances. In the drawing, for the sake of convenience in description, AND gates corresponding to second and subsequent bits have been omitted.

The k-th AND gate 571 outputs a logical AND of the k-th bit of the control signal CTLp and the enable signal AD3_EN to the CDAC 431 as the k-th bit of CTLp3.

The k-th AND gate 572 outputs a logical AND of the k-th bit of the control signal CTLn and the enable signal AD3_EN to the CDAC 432 as the k-th bit of CTLn3.

Note that each SARADC 300 includes three systems of CDACs, or may include four or more. Assuming that the number of systems is S (where S is an integer), in Fig. 22, one SARADC 300 can be arranged for every S columns. As the number of systems increases, the number of SARADCs 300 can be reduced, allowing a reduction in chip area.

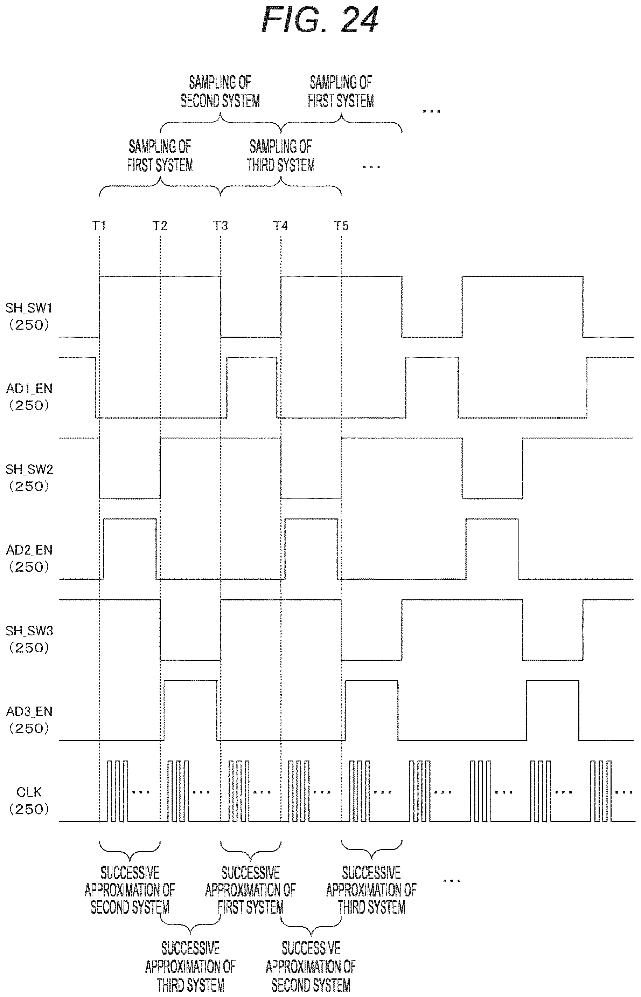

Fig. 24 is a timing chart illustrating an example of operation of the SARADC 300 according to the fifth embodiment of the present technology.

The timing control circuit 250 sets the control signal SH_SW1 to a high level during the sampling period of the first system from timing T1 to timing T3. Furthermore, the timing control circuit 250 sets the enable signal AD2_EN to a high level during a period from immediately after timing T1 to immediately before timing T2. Furthermore, the timing control circuit 250 sets the enable signal AD3_EN to a high level during a period from immediately after timing T2 to immediately before timing T3.

Within this control, the successive approximation of the second system and the successive approximation of the third system are performed during the sampling period of the first system.

Furthermore, the sampling period of the first system partially overlaps with the sampling period of the second system. The timing control circuit 250 sets the control signal SH_SW2 to a high level during the sampling period of the second system from timing T2 to timing T4. Within this sampling period, the timing control circuit 250 sets the enable signal AD1_EN to a high level during a period from immediately after timing T3 to immediately before timing T4.

Within this control, not only the successive approximation of the third system but also the successive approximation of the first system is performed during the sampling period of the second system.

Furthermore, the sampling period of the second system partially overlaps with the sampling period of the third system. The timing control circuit 250 sets the control signal SH_SW3 to a high level during the sampling period of the third system from timing T3 to timing T5. Within this sampling period, the timing control circuit 250 sets the enable signal AD2_EN to a high level during a period from immediately after timing T4 to immediately before timing T5.

Within this control, not only the successive approximation of the first system but also the successive approximation of the second system is performed during the sampling period of the third system.

The above-described control is repeated. As illustrated in the drawing, by performing, during the sampling period of one of the three systems, the successive approximation of the remaining two systems, it is possible to suppress a decrease in AD conversion speed even with longer settling time.

Note that each of the second, third, and fourth embodiments can be applied to the fifth embodiment.

As described above, according to the fifth embodiment of the present technology, the three systems of CDACs are arranged, and, during the sampling period of one of the three systems, the successive approximation of the remaining two systems is performed, allowing suppression of a decrease in AD conversion speed.

Note that the embodiments described above are merely examples for embodying the present technology, and the matters in the embodiments and the matters specifying the invention in the claims have correspondence relationships. Similarly, the matters specifying the invention in the claims and matters with the same names in the embodiments of the present technology have correspondence relationships. Note that the present technology is not limited to the embodiments, and can be embodied by applying various kinds of modifications to the embodiments without departing from the gist of the present technology.

Note that the effects described herein are merely examples and are not intended to be limiting, and other effects may also be achieved.

Note that, the present technology may also have the following configurations.
(1) An analog to digital (AD) converter including:
   a first digital-to-analog converter (DAC) having a capacitor that holds a first input signal during a first sampling period;
   a second DAC connected in parallel with the first DAC and having a capacitor that holds a second input signal during a second sampling period; and
   a comparison unit connected to the first and second DACs.
(2) The AD converter according to the above (1), further including:
   a single-ended to differential conversion circuit that converts a first single-ended signal into a first differential signal and converts a second single-ended signal into a second differential signal;
   a first sample-and-hold switch that supplies the first differential signal to the first DAC as the first input signal during the first sampling period; and
   a second sample-and-hold switch that supplies the second differential signal to the second DAC as the second input signal during the second sampling period.
(3) The AD converter according to the above (1), further including:
   a first sample-and-hold switch that supplies a first single-ended signal to the first DAC as the first input signal during the first sampling period;
   a second sample-and-hold switch that supplies a second single-ended signal to the second DAC as the second input signal during the second sampling period;
   a shared DAC;
   a first single-ended to differential conversion circuit that converts the first input signal into a differential signal and supplies the differential signal to the first DAC and the shared DAC in an interval between end of the first sampling period and start of the second sampling period; and
   a second single-ended to differential conversion circuit that converts the second input signal into a differential signal and supplies the differential signal to the second DAC and the shared DAC in an interval between end of the second sampling period and start of the first sampling period.
(4) The AD converter according to the above (1), further including:
   a first sample-and-hold switch that supplies a first single-ended signal and a reference signal to the first DAC as the first input signal during the first sampling period; and
   a second sample-and-hold switch that supplies a second single-ended signal and the reference signal to the second DAC as the second input signal during the second sampling period.
(5) The AD converter according to any one of the above (1) to (4), further including:
   a logic circuit that generates a second control signal on the basis of a comparison result of the comparison unit during the first sampling period and generates a first control signal on the basis of a comparison result of the comparison unit during the second sampling period, in which
   the first DAC generates a pair of first analog signals on the basis of the first control signal and the first input signal during the second sampling period,
   the second DAC generates a pair of second analog signals on the basis of the second control signal and the second input signal during the first sampling period, and
   the comparison unit sequentially compares the pair of first analog signals and the pair of second analog signals.
(6) The AD converter according to the above (5), further including:
   a first enable switch that supplies the pair of first analog signals to the comparison unit during the second sampling period; and
   a second enable switch that supplies the pair of second analog signals to the comparison unit during the first sampling period.
(7) The AD converter according to the above (5), in which
   the first DAC supplies the pair of first analog signals to the comparison unit,
   the second DAC supplies the pair of second analog signals to the comparison unit, and
   the comparison unit selects and compares the pair of second analog signals or the pair of first analog signals in accordance with a predetermined enable signal.
(8) The AD converter according to any one of the above (1) to (7), further including:
   a third DAC connected in parallel with the first and second DACs and having a capacitor that holds a third input signal during a third sampling period.
(9) An imaging device including:
   a pixel array unit including a plurality of pixels, each outputting a pixel signal; and
   an AD converter to which the pixel signal is input from the pixel array unit, in which
   the AD converter includes:
      a first DAC having a capacitor that holds a first input signal during a first sampling period;
      a second DAC connected in parallel with the first DAC and having a capacitor that holds a second input signal during a second sampling period, and
      a comparison unit connected to the first and second DACs.
(10) A method for controlling an AD converter, including:
   holding a first input signal during a first sampling period by a first DAC having a capacitor;
   holding a second input signal during a second sampling period by a second DAC having a capacitor and connected in parallel with the first DAC; and
   comparing a pair of analog signals by a comparison unit connected to the first and second DACs.

### REFERENCE SIGNS LIST

100 Imaging device
110 Optical system
120 Image processing unit
130 Memory
140 Imaging control unit
150 Monitor
200 Solid-state imaging element
201 Sensor chip
202 Circuit chip
210 Vertical drive circuit
220 Pixel array unit
230 Pixel
231 Photodiode
232 Transfer transistor
233 Reset transistor
234 Floating diffusion layer
235 Amplification transistor
236 Selection transistor
240 Column signal processing unit
241 Sample-and-hold circuit
242 Column amplifier
243 Switch
250 Timing control circuit
260 Output circuit
271, 272 Switching circuit
300 SARADC
311, 312, 321, 322, 331, 332 Sample-and-hold switch
313 to 317, 323 to 327, 333, 334, 352, 514, 515, 524, 525 Enable switch
340, 341, 342 Single-ended to differential conversion circuit
351 OR (logical OR) gate
411, 412, 421, 422, 430, 431, 432 CDAC
441, 442 Capacitor
500 Control unit
510 Comparison unit
511 to 513, 521 to 523 nMOS transistor
516, 526, 551, 552, 561, 562, 571, 572 AND (logical AND) gate
531, 532 pMOS transistor
550 Latch
580 SAR logic circuit

## Claims

1. An analog to digital (AD) converter comprising:
a first digital-to-analog converter (DAC) having a capacitor that holds a first input signal during a first sampling period;
a second DAC connected in parallel with the first DAC and having a capacitor that holds a second input signal during a second sampling period; and
a comparison unit connected to the first and second DACs.

2. The AD converter according to claim 1, further comprising:
a single-ended to differential conversion circuit that converts a first single-ended signal into a first differential signal and converts a second single-ended signal into a second differential signal;
a first sample-and-hold switch that supplies the first differential signal to the first DAC as the first input signal during the first sampling period; and
a second sample-and-hold switch that supplies the second differential signal to the second DAC as the second input signal during the second sampling period.

3. The AD converter according to claim 1, further comprising:
a first sample-and-hold switch that supplies a first single-ended signal to the first DAC as the first input signal during the first sampling period;
a second sample-and-hold switch that supplies a second single-ended signal to the second DAC as the second input signal during the second sampling period;
a shared DAC;
a first single-ended to differential conversion circuit that converts the first input signal into a differential signal and supplies the differential signal to the first DAC and the shared DAC in an interval between end of the first sampling period and start of the second sampling period; and
a second single-ended to differential conversion circuit that converts the second input signal into a differential signal and supplies the differential signal to the second DAC and the shared DAC in an interval between end of the second sampling period and start of the first sampling period.

4. The AD converter according to claim 1, further comprising:
a first sample-and-hold switch that supplies a first single-ended signal and a reference signal to the first DAC as the first input signal during the first sampling period; and
a second sample-and-hold switch that supplies a second single-ended signal and the reference signal to the second DAC as the second input signal during the second sampling period.

5. The AD converter according to claim 1, further comprising:
a logic circuit that generates a second control signal on a basis of a comparison result of the comparison unit during the first sampling period and generates a first control signal on a basis of a comparison result of the comparison unit during the second sampling period, wherein
the first DAC generates a pair of first analog signals on a basis of the first control signal and the first input signal during the second sampling period,
the second DAC generates a pair of second analog signals on a basis of the second control signal and the second input signal during the first sampling period, and
the comparison unit sequentially compares the pair of first analog signals and the pair of second analog signals.

6. The AD converter according to claim 5, further comprising:
a first enable switch that supplies the pair of first analog signals to the comparison unit during the second sampling period; and
a second enable switch that supplies the pair of second analog signals to the comparison unit during the first sampling period.

7. The AD converter according to claim 5, wherein
the first DAC supplies the pair of first analog signals to the comparison unit,
the second DAC supplies the pair of second analog signals to the comparison unit, and
the comparison unit selects and compares the pair of second analog signals or the pair of first analog signals in accordance with a predetermined enable signal.

8. The AD converter according to claim 1, further comprising:
a third DAC connected in parallel with the first and second DACs and having a capacitor that holds a third input signal during a third sampling period.

9. An imaging device comprising:
a pixel array unit including a plurality of pixels, each outputting a pixel signal; and
an AD converter to which the pixel signal is input from the pixel array unit, wherein
the AD converter includes:
a first DAC having a capacitor that holds a first input signal during a first sampling period;
a second DAC connected in parallel with the first DAC and having a capacitor that holds a second input signal during a second sampling period, and
a comparison unit connected to the first and second DACs.

10. A method for controlling an AD converter, comprising:
holding a first input signal during a first sampling period by a first DAC having a capacitor;
holding a second input signal during a second sampling period by a second DAC having a capacitor and connected in parallel with the first DAC; and
comparing a pair of analog signals by a comparison unit connected to the first and second DACs.
